# EUROPÄISCHE PATENTSCHRIFT

(11) **EP 0 452 745 B1**
(45) Veröffentlichungstag und Bekanntmachung des Hinweises auf die Patenterteilung: **27.12.1995**
(21) Anmeldenummer: 91105383.3
(22) Anmeldetag: 05.04.1991
(51) Int. Cl.: C23C 16/44, H01J 37/32

(54) **Verfahren zur reaktiven Oberflächenbehandlung**
Process for reactive surface treatment
Procédé de traitement de surface réactif

(30) Priorität: 12.04.1990 DE 4011933
(43) Veröffentlichungstag der Anmeldung: 23.10.1991
(73) Patentinhaber: BALZERS AKTIENGESELLSCHAFT, 9496 Balzers (LI)
(72) Erfinder: Fischer, Heinrich, FL-9495 Triesen (LI)
(74) Vertreter: Troesch Scheidegger Werner AG

(56) Entgegenhaltungen:
- EP-A- 0 019 370
- US-A- 4 870 923
- PATENT ABSTRACTS OF JAPAN, Band 5, Nr. 59 (E-53)[731], 22. April 1981; & JP-A-56 10 932 (MITSUBISHI DENKI K.K.) 03-02-1981
- PATENT ABSTRACTS OF JAPAN, Band 13, Nr. 423 (C-638)[3771], 20. September 1989; & JP-A-1 162 772 (FUJITSU LTD) 27-06-1989

## Beschreibung

Die vorliegende Erfindung betrifft ein Verfahren zur reaktiven Oberflächenbehandlung nach dem Oberbegriff von Anspruch 1.

Grundsätzlich bezieht sich die vorliegende Erfindung auf die Ausbildung der Gasströmung bei reaktiven Oberflächenbehandlungsprozessen, d.h. die Zuführung eines Arbeitsgases mit bei der Oberflächenbehandlung chemisch reagierenden Gasanteilen, sowie der Absaugung von Gas aus der Behandlungskammer, welches Reaktionsprodukte der genannten Reaktion umfasst.

Aus der FR-A-26 23 524 ist ein CVD-Beschichtungsverfahren bekannt, bei welchem das Arbeitsgas seitlich der zu behandelnden Oberfläche in die Kammer eingelassen wird und Gas mit dem Reaktionsprodukt aus einer Mehrzahl der Oberfläche gegenüberliegenden Absaugöffnungen abgeführt wird.

Aus der EP-A-0 283 007 ist ein CVD-Beschichtungsverfahren bekannt, bei welchem das Arbeitsgas aus einer Mehrzahl von der zu beschichtenden Oberfläche gegenüberliegender Oeffnungen in die Kammer eingelassen wird und Gas mit Reaktionsprodukten seitlich neben der zu behandelnden Oberfläche abgesaugt wird.

Aus der EP-A-0 322 466 ist ein plasmaunterstütztes (PE-)CVD-Verfahren bekannt, bei welchem das Arbeitsgas aus einer Mehrzahl der zu behandelnden Oberfläche gegenüberliegenden Oeffnungen eingelassen wird, Reaktionsprodukte aus einer Absaugöffnung abgeführt werden, welche, bezüglich des Werkstückes, den Einlassöffnungen im wesentlichen gegenüberliegt, so dass die Gasströmung radial um die Peripherie des Werkstückes herum zur Absaugöffnung erfolgt.

Aus der EP-A-0 303 508 ist wiederum ein PECVD-Verfahren bekannt, bei welchem das Arbeitsgas, bei in Arbeitsposition liegendem Werkstück, aus einer Mehrzahl der zu behandelnden Oberfläche gegenüberliegenden Oeffnungen zugeführt wird, wobei Gas mit den Reaktionsprodukten seitlich der zu behandelnden Oberfläche abgesaugt wird.

Im Rahmen von sowohl unter atmosphärischen Druckverhältnissen wie auch unter Vakuumverhältnissen durchgeführten CVD-Verfahren ist es aus der US-A-4 817 558 bekannt, Arbeitsgas aus der zu behandelnden Oberfläche gegenüberliegenden Oeffnungen zuzuführen und Reaktionsprodukte wiederum seitlich bzw. peripher der zu behandelnden Oberfläche abzusaugen.

Aus der EP-A-0 254 654 anderseits ist es bekannt, das Gas im wesentlichen über die ganze zu behandelnde Oberfläche strömen zu lassen, d.h. das Arbeitsgas auf einer Seite der zu behandelnden Oberfläche einzulassen und auf der anderen Seite wieder abzusaugen.

Schliesslich ist es aus der US-A-4 297 162 bekannt, bei einem RF-Plasma-Aetzverfahren das Arbeitsgas aus einer Mehrzahl der zu behandelnden Oberfläche gegenüberliegenden Oeffnung zuzuführen, wobei die Oeffnungen bezüglich der zu behandelnden Oberfläche unterschiedlich beabstandet sind, um ein angestrebtes Aetzprofil an der Werkstückoberfläche zu erreichen. Ueber die an der Kammer angeschlossene Vakuumpumpe wird Gas aus der Kammer abgesaugt, damit Reaktionsprodukte des reaktiven Aetzprozesses. Die Absaugleitung ist bezüglich des zu behandelnden Werkstückes auf der den Einlassöffnungen entgegengesetzten Seite angeordnet, derart, dass die Gasströmung radial um die Peripherie des Werkstückes herum zu der zentral darunter angeordneten Absaugleitung hin erfolgt.

Bei reaktiven Oberflächenbehandlungsprozessen, bei denen mindestens ein Anteil eines Arbeitsgases chemisch reagiert, ist dem Konzentrationsverhältnis von noch unverbrauchten Reaktionsgas und von gasförmigen Reaktionsprodukten in unmittelbarem Bereich zu der zu behandelnden Oberfläche für die Behandlungswirkung, d.h. die Beschichtungsrate bzw. Aetzrate, grosse Bedeutung beizumessen. Unter dem Begriff "Rate" wird verstanden: Menge pro Zeiteinheit.

Wenn ein Strom frisch zugeführten, reaktiven Arbeitsgases über die Oberfläche streicht und dort reagiert, wird in diesem Strom das genannte Verhältnis kontinuierlich zu Ungunsten des frischen reaktiven Gases verändert, womit sich auch die Behandlungswirkung entlang der überstrichenen Oberfläche ändert. Diesem Phänomen wird bei den obgenannten bekannten Vorgehensweisen nicht Rechnung getragen. Immer dann, wenn grossflächig eine Gasstromung im wesentlichen kontinuierlich über die zu behandelnde Oberfläche streicht, tritt das erwähnte Phänomen ein. Dies somit dann, wenn aus mehreren Arbeitsgaseinlässen der zu behandelnden Oberfläche Arbeitsgas zugeführt wird und diesbezüglich peripher Gas mit Reaktionsprodukten abgesaugt wird: Dann entsteht eine grossräumige, im wesentlichen radiale oder vom Zentrum zur Peripherie hin gerichtete Gasströmung.

Aus der DE-OS-30 20 815 ist es bekannt, bei einem plasmaunterstützten, reaktiven Beschichtungsprozess das Arbeitsgas aus einem Vorratsraum durch Oeffnungen in der einen Glimmentladungselektrode in die eigentliche Behandlungskammer zwischen den Elektroden einzulassen und Reaktionsprodukte durch die gleichen Oeffnungen in den gleichen Vorratsraum aus der Behandlungskammer abzuführen, wobei der Strom von Arbeitsgas hin in die Behandlungskammer zurück in den Vorratsraum aufgrund von Gasdiffusion erfolgt.

Bei diesem Vorgehen ist die Verteilung von Arbeitsgas und Reaktionsprodukten in der Behandlungskammer kaum beherrschbar. So ist nicht gewahrleistet, dass in überwiegendem Masse frisches Reaktionsgas im Bereich des zu beschichtenden Werkstückes vorhanden ist, weil dies massgeblich von der Reaktionsverteilung in der Behandlungskammer sowie von den Diffusionsgeschwindigkeiten frischen Reaktionsgases einerseits und der Reaktionsprodukte anderseits abhängt.

Nun ist es aus der US-A-4 209 357 bekannt, im Rahmen eines Plasmaätzverfahrens der zu behandelnden Werkstückoberfläche gegenüberliegend sowohl eine Mehrzahl von Einlassöffnungen für das Arbeitsgas wie auch eine Mehrzahl von Absaugöffnungen vorzusehen, welche gemeinsam eine gleichförmige Arbeitsgaszuführung und Gasabsaugung in den Reaktionsraum erlauben. In einem gleichförmig verteilten Feld wird dadurch ein gleichförmig verteilter Gaseinlass und ein gleichförmig verteilter Gasauslass erreicht.

Der Erfindung liegt die Aufgabe zugrunde, ein Verfahren und eine Behandlungskammer der eingangs genannten Art zur Verwendung insbesondere bei einem CVD- oder einem reaktiven PVD-Verfahren zu schaffen, mit denen
a) die Behandlungswirkung in einem Bereich der zu behandelnden Werkstückoberfläche selektiv beeinflusst werden kann.
b) das zugeführte, reaktive Gas zur Oberflächenbehandlung besser ausgenützt wird.

Dies wird beim Verfahren eingangs genannter Art bei Vorgehen gemäss dem Wortlaut des kennzeichnenden Teils von Anspruch 1 erreicht.

Grundsätzlich geht die vorliegende Erfindung von der Erkenntnis aus, dass dann, wenn, im Unterschied zu den obgenannten Techniken, nicht eine grossräumige Gasströmung entlang der zu behandelnden Oberfläche erzeugt wird, sondern selektive Oberflächenbereiche gebildet werden, wo Gas zu der zu behandelnden Oberfläche hinströmt, dort umgelenkt wird und daneben wieder rückströmt, das Problem, dass sich frisches Reaktionsgas mit zunehmendem Fliessweg entlang der zu behandelnden Oberfläche zunehmend verbraucht und mithin entlang der Oberfläche unterschiedliche Behandlungsbedingungen auftreten, gelost wird und dass sich damit die Möglichkeit ergibt, gezielt an Bereichen der Oberfläche selektiv die Behandlungswirkung zu beeinflussen.

Es wird weiter, weil sich keine "Seen" nicht reagierenden oder wenig reagierenden frischen Reaktionsgases bilden, das dem Prozess bzw. der Kammer zugeführte frische Reaktionsgas zu einem wesentlich höheren Anteil behandlungswirksam ausgenützt.

Im Unterschied zu den bisher bekannten Techniken wird mithin erfindungsgemäss grundsätzlich die zu behandelnde Oberfläche bezüglich Einlass- und Absaugöffnung so nahe angeordnet, dass im unmittelbar darunter liegenden Oberflächenbereich noch eine Gasströmung vorherrscht, die durch die an diesen Oeffnungen eingestellten oder vorherrschenden Aus- bzw. Einströmungsverhältnisse gegeben ist. Dies ist daran erkennbar, dass dann, wenn der Gaseinlass und der zugehörige Gasauslass, wie durch Aenderung des Ausdüsungsimpulses an der Einlassöffnung und/oder der Formgebung des Einlasses bzw. des rückgesaugten Massestromes bzw. die Ausbildung der Absaugöffnung, geändert werden, sich im Oberflächenbereich, unmittelbar unterhalb der genannten beiden Oeffnungen liegend, eine Aenderung der Behandlungswirkung, sei dies der Beschichtungsrate oder der Aetz- bzw. Sputterrate, ergibt, in den benachbarten Oberflächenbereichen diese Aenderung jedoch im wesentlichen wirkungslos bleibt. Dabei ist aber selbstverständlich zu berücksichtigen, dass die dementsprechend sich ändernde Behandlungswirkung nur stetig in den angrenzenden Bereichen verschwindet.

Es ergibt sich bei Vorgehen nach Anspruch 2 oder 3 ein Strömungsbild nach einer Raumfläche entsprechend einem U, das um seinen einen Schenkel rotiert. Damit wird der selektiv beeinflusste Bereich der zu behandelnden Oberfläche gross.

Das vorgeschlagene Verfahren eignet sich sowohl für Oberflächenbehandlungsprozesse unter Atmosphärendruck wie auch unter Vakuumbedingung. Vor allem eignet es sich für CVD-Verfahren, insbesondere für pyrolytische CVD-Verfahren. Für pyrolytische CVD-Verfahren deshalb, weil dort, ohne Plasmaunterstützung, die Behandlungswirkungsverteilung in weitestgehendem Masse von der genannten Gasströmung abhängt, während bei plasmaunterstützten CVD-Verfahren auch Parameter der Plasmaentladung diese Verteilung massgebend beeinflussen können. Dabei ist es aber selbstverständlich möglich, durch erfindungsgemässes Vorgehen auch hier eine bestimmte SOLL-Verteilung zu erwirken und ungewollten, entladungsbedingten Einflüssen entgegenzuwirken.

In Anbetracht dieser Tatsache eignet sich das erfindungsgemässe Vorgehen auch für Verfahren mit elektrischer DC-oder AC-Entladung, letzteres gegebenenfalls mit DC-Vorspannung (Biasing) des Werkstückes in an sich bekannter Art und Weise. Ebenfalls in bekannter Art und Weise wird die Entladung mit AC im HF-Bereich oder im Mikrowellenbereich gespiesen.

Im weiteren eignet sich das vorgeschlagene Vorgehen aber auch für reaktive PVD-Verfahren, bei denen sowohl physikalische (Ionisation) Vorgänge ablaufen wie auch chemische Gasreaktionen. Grundsätzlich eignet sich mithin das vorgeschlagene Vorgehen für Prozesse, bei denen Gas infolge einer Reaktion, insbesondere im Bereich der zu behandelnden Oberfläche, "verbraucht" wird.

Die Erfindung wird anschliessend beispielsweise anhand von Figuren erläutert.

Es zeigen:
- Fig. 1: schematisch eine Raumfläche in einer (nicht dargestellten) Behandlungskammer mit Einlassöffnungen für ein Arbeitsgas und Absaugöffnungen für gasförmige Reaktionsprodukte, zur Erläuterung des grundsätzlich gemäss der vorliegenden Erfindung begangenen Weges,
- Fig. 1a: einen Ausschnitt aus der Anordnung von Fig. 1 zur Erläuterung der erfindungsgemässen Wirkungsbeeinflussung,
- Fig. 2: eine Darstellung analog zu Fig. 1, mit unterschiedlich beabstandeten Einlassöffnungen und Absaugöffnungen und dem daraus resultierenden, erfindungsgemäss ausgenützten Reaktionsraumvolumenbereich,
- Fig. 3a bis 3d: schematisch vier beispielsweise Oeffnungsanordnungen, bei einer erfindungsgemässen Anordnung,
- Fig. 4: schematisch im Längsschnitt eine zur Durchführung des erfindungsgemässen Verfahrens geeignete Vakuumbehandlungskammer, ausgebildet als Plasma-CVD-Kammer,
- Fig. 5: schematisch die Aufsicht auf eine Einlass-/Absaugöffnungsplatte, wie als Beispiel an der Anordnung gemäss Fig. 4 vorgesehen,
- Fig. 6: eine Anordnung, dargestellt analog zu derjenigen von Fig. 4, für pyrolytische CVD-Beschichtung eines Werkstückes,
- Fig. 7a: an der Anordnung gemäss Fig. 6 erzielte Strömungsverhältnisse, qualitativ dargestellt,
- Fig. 7b: eine ungünstige Gasströmung entlang der Werkstückoberfläche, wie sie erfindungsgemäss zu vermeiden ist,
- Fig. 8: eine Schnittdarstellung einer Ausführungsvariante einer Einlass-/Absaugöffnungsanordnung, sei dies zusätzlich als Elektrode geschaltet, wie für einen Plasmaätz- oder -CVD-Prozess, oder elektrisch neutral betrieben, wie für einen pyrolytischen CVD-Prozess,
- Fig. 9: einen Schnitt gemäss Linie VI-VI durch die Platte gemäss Fig. 6.

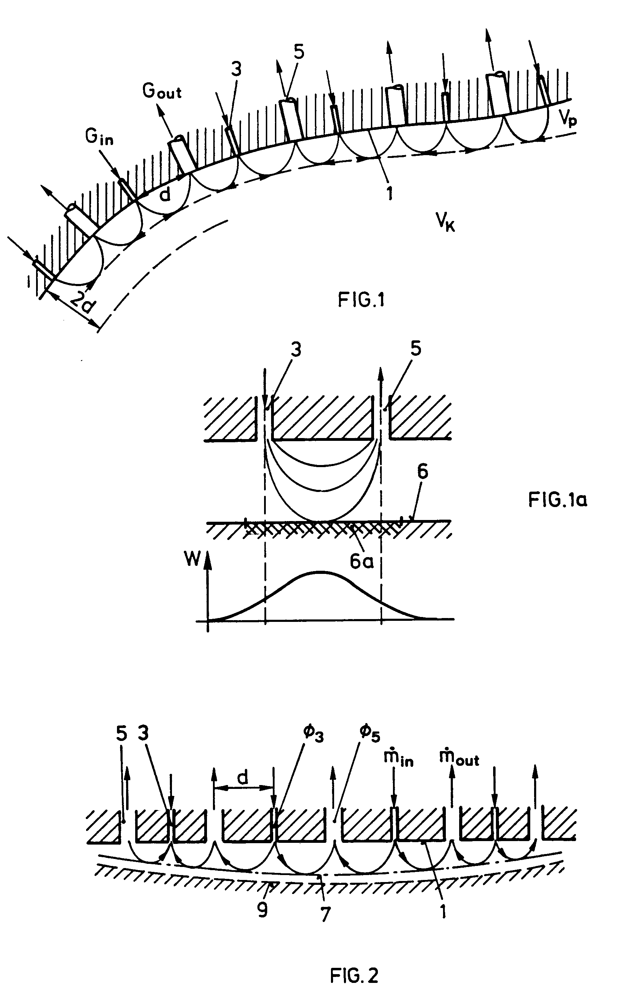

In Fig. 1 ist schematisch und prinzipiell das erfindungsgemässe Vorgehen in einer hier nicht dargestellten Behandlungskammer dargestellt.

Es ist an einer Berandungsfläche 1 des Kammerreaktionsvolumens V_{K} eine Anordnung von Einlassöffnungen 3 für Arbeitsgas Gᵢₙ vorgesehen, durch die das für den reaktiven Behandlungsprozess benötigte Arbeitsgas eintritt. Weiter sind Absaugöffnungen 5 vorgesehen, an denen aus dem Volumen V_{K} Gas mit Reaktionsprodukten abgesaugt wird. Es sind die Einlassöffnungen 3 und Absaugöffnungen 5 einander unmittelbar benachbart. Die Hauptströmungsrichtungen einander benachbarter Einlass- bzw. Absaugöffnungen 3, 5 sind im wesentlichen parallel.

Zum Ausdruck "unmittelbar benachbart": Wenn von einer betrachteten Oeffnung 3 oder 5 der einen Art (z.B. Einlassöffnung) auf diesbezüglich konzentrischen Kreisen, gegebenenfalls Kugelflächen, der Abstand vergrössert wird, so ist die eine oder sind die weiteren Oeffnungen, auf die zuerst gestossen wird, anderer Art, d.h. 5 oder 3 (z.B. Absaugöffnungen).

Das Kammer- bzw. Prozessvolumen V_{K} wird nur im Nahbereich zu den Einlass-/Absaugöffnungspaaren 3, 5 zum Anordnen der erfindungsgemäss zu behandelnden Oberfläche ausgenützt.

In Fig. 1 ist gestrichelt bezüglich der Oberfläche 1 eingetragen, welcher Volumenteil Vₚ erfindungsgemäss ausgenützt wird. Rein qualitativ eingetragen, sind zwischen Paaren von Einlass- und Absaugöffnungen entstehende U-Strömungen dargestellt. Wie weit das U-förmige Gasströmungsfeld sich benachbarter Oeffnungen 3, 5 in den Prozessraum hinein erstreckt, hängt im wesentlichen ab von:
- den Gaseinlassverhältnissen, d.h. letztendlich dem Impuls des eingedüsten Gases,
- den Druckverhältnissen in der Kammer,
- den Gasabsaugverhältnissen, d.h. dem abgesaugten Volumen- oder Massestrom.

Als Richtlinie bei Vakuumprozessen lassen sich Aenderungen dieser Grösse bis ca. zum doppelten Oeffnungsabstand 2d registrieren.

In Fig. 1a ist eine Einlassöffnung 3 und eine Absaugöffnung 5 sowie die dazwischen herrschende Gasströmung qualitativ dargestellt bezüglich einer zu behandelnden Oberfläche 6. Werden die Einlassverhältnisse und/oder die Absaugverhältnisse verändert, indem beispielsweise der Impuls des an der Oeffnung 3 ausgegebenen Gases erhöht wird, und/oder der an der Absaugleitung 5 rückgesaugte Volumen- bzw. Massestrom, so ergibt sich dann, wenn die zu behandelnde Oberfläche 6 mit ihrem den beiden Oeffnungen 3 und 5 gegenüberliegenden Bereich 6a, der vorliegenden Erfindung folgend, von den beiden Oeffnungen 3, 5 beabstandet ist, eine Behandlungswirkungsänderung w, wie sie qualitativ dargestellt ist: Im wesentlichen stellt sich an dem den Oeffnungen gegenüberliegenden Bereich 6a eine Aenderung der Behandlungswirkung w ein, sei dies der Aetz- bzw. Sputterrate oder der Beschichtungsrate, und zwar im wesentlichen nur in diesem Bereich und nicht in den benachbarten der Oberfläche 6.

Gemäss Fig. 2 kann nun die Behandlungswirkungsverteilung durch Variation der Paarabstände d an der hier ebenen Fläche 1 geändert werden oder durch Variation der Einlassverhältnisse, der Absaugverhältnisse, wie der Einlassförderleistung, der Absaugleistung.

In Fig. 2 ist eine Variation der Oeffnungsabstände d dargestellt. Strichpunktiert ist qualitativ eine Fläche 7 eingetragen, auf der, genähert, gleiche lokale Behandlungswirkungen auftreten. Durch gezielte Variation der lokalen Paarabstände d und/oder, wie erwähnt, durch Variation von Einlass- bzw. Absaugöffnungsdurchmessern φ₃ und φ₅ bzw. der pro Zeiteinheit zugeführten bzw. abgesaugten Gasmasse ṁᵢₙ, ṁₒᵤₜ, bzw. des Einlassimpulses, lassen sich im erfindungsgemäss ausgenützten Volumenteil Vₚ erwünschte Wirkungsverteilungen einstellen und, entsprechend, eine zu behandelnde Werkstückoberfläche, nach einer erwünschten Behandlungswirkungsverteilung an seiner Oberfläche, im genannten Volumenteil Vₚ, wie bei 9 angedeutet, anordnen.

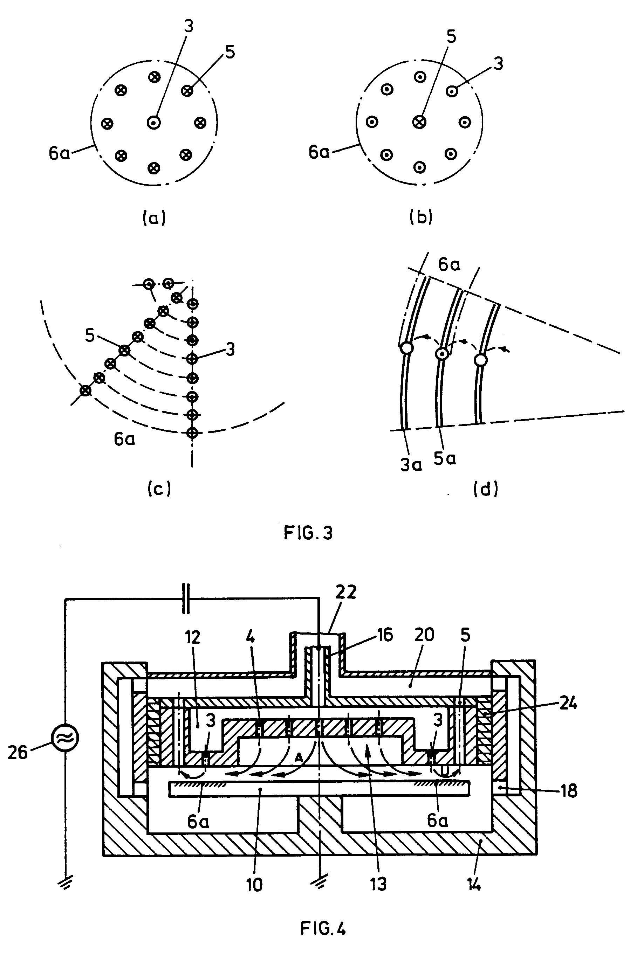

In Fig. 3 sind beispielsweise vier mögliche Anordnungen von Einlassöffnungen 3 bzw. Absaugöffnungen 5 dargestellt. Gemäss Fig. 3a sind jeweils einer Einlassöffnung 3, auf einem diesbezüglich konzentrischen Kreis, mehrere Absaugöffnungen 5 vorgesehen. Diese Oeffnungen bilden bezüglich des strichpunktiert eingetragenen Bereiches 6a erfindungsgemäss gekoppelt betriebene Einlass- bzw. Absaugöffnungen.

In Fig. 3b sind die Verhältnisse umgekehrt; einer zentralen Absaugöffnung 5 sind, auf einem konzentrischen Kreis, mehrere Einlassöffnungen 3 zugeordnet, die gemeinsam erfindungsgemäss die Behandlungswirkung w an dem Oberflächenbereich 6a beeinflussen.

In Fig. 3c ist, beispielsweise zur Oberflächenbehandlung von kreisförmigen Substraten, ein Ausschnitt aus der Oeffnungsanordnung dargestellt, gebildet durch radial angeordnete Reihen von Einlassöffnungen 3 bzw. ihnen zugeordnete Absaugöffnungen 5. Das Strömungsbild wird damit im wesentlichen azimutal, wie gestrichelt eingetragen; jeweils zwei einander benachbarte Oeffnungsreihen wirken im wesentlichen auf einen sektorförmigen Bereich 6a.

In Fig. 3d sind, ebenfalls beispielsweise, zur Oberflächenbehandlung kreisförmiger Substrate anstelle einzelner Lochöffnungen Einlassschlitze 3a bzw. Absaugschlitze 5a azimutal angeordnet, womit ein im wesentlichen radiales Strömungsbild erzeugt wird und wobei sich benachbarte Oeffnungen 3a bzw. 5a auf ringförmige Oberflächenbereiche 6a einwirken.

Dank des erfindungsgemässen Vorgehens, womit die durch die Einlassöffnung und die Absaugöffnung bewirkten Strömungen an der zu behandelnden Oberfläche zur Geltung gebracht werden, ist es möglich, durch gezielte Auslegung deren Strömungsbilder bzw. -felder gezielte Beschichtungswirkungsverteilungen, wie Aetz- oder Sputterratenverteilung oder Beschichtungsratenverteilung an der zu behandelnden Werkstückoberfläche, zu erzielen.

In Fig. 4 ist schematisch der Längsschnitt durch eine zur Realisation der vorliegenden Erfindung aufgebaute Vakuumbehandlungskammer dargestellt. Es handelt sich dabei, als Beispiel, um eine Plasma-CVD-Oberflächenbehandlungskammer mit RF-Plasmaerzeugung. In dieser Anordnung ist das erfindungsgemässe Vorgehen nur gezielt in einem wohl definierten Bereich des Reaktionsvolumens ausgenützt.

Wie beispielsweise aus der EP-A-0 322 466 für Plasma-CVD bekannt, wird aus einer Anordnung 13 im wesentlichen gleich verteilter, gleicher Einlassöffnungen 4, aus einer Arbeitsgasverteilkammer 12, einem Substrat 10 gegenüberliegend, letzterem Arbeitsgas mit Reaktionsgas zugeführt, A. Der Verteilkammer 12 wird Gas durch eine Leitung 16 zugeführt.

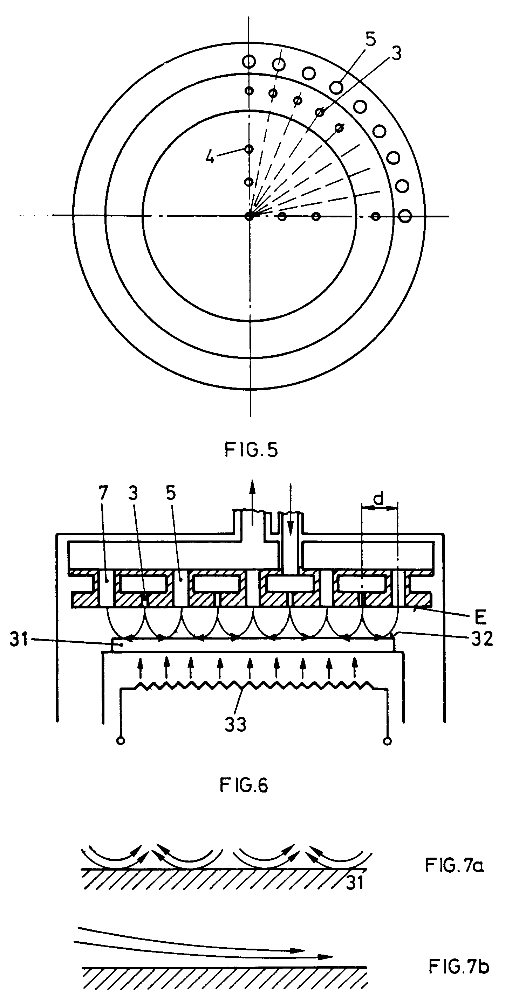

Beispielsweise, wie in Fig. 5 dargestellt, im Peripheriebereich bezüglich des Substrates 10, sind Paare von Einlassöffnungen 3 und Absaugöffnungen 5 vorgesehen, bezüglich der Oberfläche des Substrates 10 gemäss der vorliegenden Erfindung beabstandet.

Es entspricht die Anordnung der Oeffnungspaare 3, 5 der vorliegenden Erfindung, während die Gaseindüsöffnungen 4 im Zentrumsbereich und die im Peripheriebereich der Behandlungskammer 14 angeordneten Absaugöffnungen 18 dem Stande der Technik entsprechen.

Die erfindungsgemäss angeordneten Absaugöffnungen 5 sowie die gemäss Stand der Technik angeordneten, peripheren Absaugöffnungen 18 kommunizieren mit einer Gassammelkammer 20, angeschlossen an eine Rücksaugleitung 22. Die Einlassöffnungen 4 gemäss Stand der Technik und die gemäss vorliegender Erfindung vorgesehenen Einlassöffnungen 3 kommunizieren ihrerseits mit der Gasverteilkammer 12. Die Anordnung mit den Einlassöffnungen 3 und 4 sowie den Absaugöffnungen 5 ist, wie schematisch bei 24 dargestellt, elektrisch bezüglich der Wandung der Kammer 14 isoliert und wird im speziell betrachteten Fall von einem RF- bzw. HF-Generator 26 betrieben. Das Substrat 10 und die Wand der Kammer 14 liegen beispielsweise auf Massepotential. Ohne weiteres kann aber das Substrat 10 auf DC-Potential gespannt sein.

Wie nun ersichtlich, ist der Abstand der Substratoberfläche im Zentralbereich von den Eindüsöffnungen 4 wesentlich grösser als im Peripheriebereich von den Oeffnungspaaren 3, 5. Während im erstgenannten Bereich, wegen des dort grossen Abstandes innerhalb des Plasmaraumes, zwischen der als RF-Elektrode wirkenden Einlass-/Absaugöffnungsanordnung und dem geerdeten Substrat 10, sich eine nicht beherrschbare, im wesentlichen radial nach aussen abnehmende Ratenverteilung von zugeführtem, frischem Reaktionsgas und gasförmigen Reaktionsprodukten an der Substratoberfläche einstellt, wird im erfindungsgemäss bestückten Peripheriebereich diese Rate durch die dort realisierten Einlass-/Absaugöffnungs-Paarabstände bezüglich des Abstandes zur Substratoberfläche beherrschbar. Dort ist die Substratoberfläche erfindungsgemäss nur so weit von den Oeffnungspaaren 3, 5 entfernt, dass die durch die Oeffnungen 3, 5 bewirkte, lokale U-Strömung am dort gelegenen Bereich 6a entlangstreicht.

Damit wird im dort ausgenützten Reaktionsraum, der wesentlich weniger tief ist als im Zentralbereich, die erwähnte Rate erfindungsgemäss beeinflussbar.

In Fig. 5 ist schematisch eine Aufsicht auf die Anordnung der Einlassöffnungen 4 und der vorgesehenen Oeffnungspaare 3, 5 an der Behandlungskammer gemäss Fig. 4 dargestellt.

Fig. 6 zeigt, in analoger Darstellung zu Fig. 4, eine Behandlungskammer für einen Oberflächenreaktionsprozess, insbesondere eine Kammer für pyrolytische CVD-Beschichtung. Der Prozess kann je nach Prozessanforderungen bei atmosphärischen Druckverhältnissen oder im Vakuum ausgeführt werden.

Ein zu beschichtendes Substrat 31 ruht auf einer beheizten Trägeroberfläche, die, wie schematisch angedeutet, beispielsweise mittels einer Elektroheizung 33, zur Zuführung der Reaktionsenergie an die Substratoberfläche 32, beheizt ist. Der zu beschichtenden Oberfläche 32 des Substrates 31 gegenüberliegend, ist eine Anordnung verteilter Einlassöffnungen 3 und Absaugöffnungen 5 vorgesehen, wobei, im dargestellten Beispiel, die Abstände d zwischen sich benachbarten Einlass- und Absaugöffnungen 3, 5 gleich sind.

Das Substrat 31 ist auf einer zur Ausmündungs- bzw. Einmündungsebene E der Oeffnungen 3, 5 aequidistanten Ebene gehaltert, und zwar bezüglich der Ebene E auf einem Abstand, der den erfindungsgemässen Anforderungen bezüglich bereichsselektiven Aenderungen aufgrund von Einlass- und/oder Absaugverhältnisänderungen genügt.

Wie aus Fig. 7a weiter ersichtlich, ergibt sich lokal an der Oberfläche des Substrates 31 eine Arbeitsgaszufuhr bzw. Reaktionsproduktabfuhr, die durch die Anordnung der Oeffnungspaare gezielt beeinflusst werden kann und insbesondere über der Oberfläche homogen ausgebildet werden kann, auch bei sehr ausgedehnten Substratoberflächen.

Wie in Fig. 7b dargestellt, lässt sich eine solche Beeinflussung dann lokal nicht mehr vornehmen, wenn das zugeführte Arbeitsgas über längere Substratoberflächenbereiche hinwegstreicht und zunehmend verbraucht wird.

Zudem ergibt sich durch die Strömungsausnützung nach der vorliegenden Erfindung eine wesentliche Verbesserung des Wirkungsgrades bezüglich zugeführter Arbeitsgasmenge: Praktisch das gesamte, dem Reaktionsraum zugeführte Arbeitsgas gelangt in den unmittelbaren Bereich der heissen Substratoberfläche und reagiert dort, während, gemäss Fig. 7b, die einmal in diesen Bereich des Substrates gelangte Gasmenge, zunehmend verbraucht, an dieser Oberfläche verbleibt.

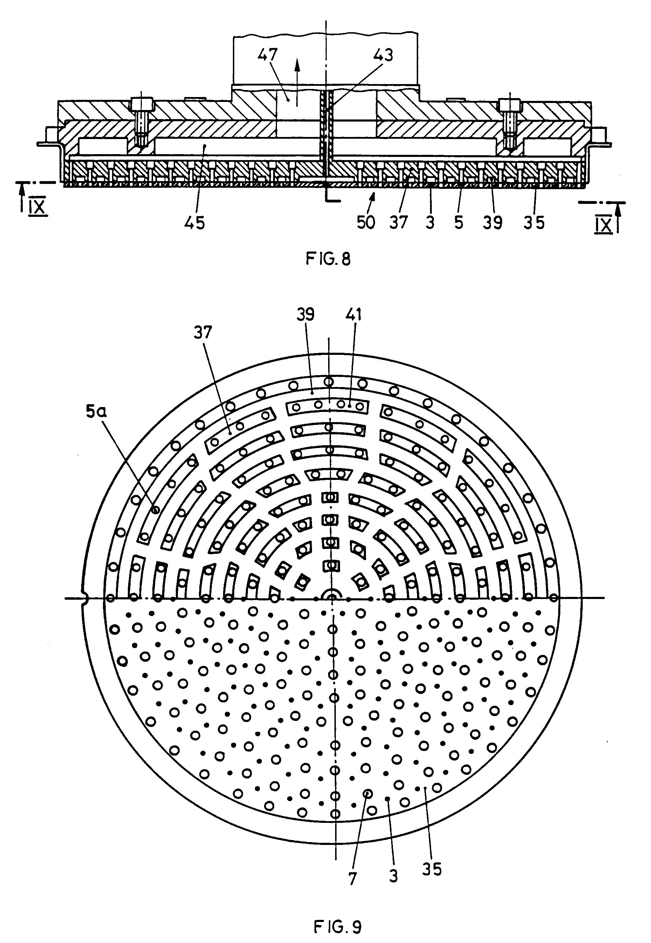

In den Fig. 8 und 9 ist eine bevorzugte Realisationsvariante für die Gaseinlass- und -absaugöffnungen dargestellt.

Die Anordnung mit den Einlass-/Absaugöffnungen 3, 5 umfasst eine Aussenplatte 35 mit, gemäss Fig. 9, kleindurchmessrigen Einlassöffnungen 3 und grösser dimensionierten Absaugöffnungen 5. Die Einlassöffnungen 3 kommunizieren mit einer in einer Platte 37 eingearbeiteten Nut 39, welche sich in konzentrischen, radial verbundenen Kreisen über die Fläche der Platte 37 erstreckt oder auch beispielsweise mäanderförmig ausgebildet sein kann.

Die von der Nut 39 ausgenommenen Partien 41 der Platte 37 liegen dichtend an der Aussenplatte 35 an. In diese Partien 41 sind die Absaugöffnungen 5 als Bohrungen 5a eingearbeitet. Der durch die Nut 39 gebildeten Verteilkammer wird frisches Arbeitsgas zentral durch die Leitung 43 zugeführt. Die Bohrungen 5a ihrerseits kommunizieren mit einer Gassammelkammer 45, die über eine Leitung 47 mit einer Rücksaugquelle in bekannter Art und Weise verbunden ist.

Es versteht sich von selbst, dass die Nut 39 auch in die Aussenplatte 35 eingearbeitet sein kann.

Durch die Ausbildung der Verteilkammer als Nut 39 wird eine einfache Möglichkeit geschaffen, die Anordnung von beabstandeten Oeffnungspaaren zu realisieren. Es kann an einer Kammer die eine Oeffnungsanordnung gemäss Fig. 8 und 9 leicht durch eine andere ersetzt werden, je nach den erwünschten, auszunützenden Strömungsverhältnissen bei der Werkstückbehandlung.

Selbstverständlich kann die ganze Anordnung, wie sie in den Fig. 8 und 9 dargestellt ist, im Falle des Einsatzes in einem Plasma-Vakuumbehandlungsprozess elektrisch auf Potential gelegt werden oder als elektrisch geerdete Elektrode gegen ein auf Potential gelegtes Werkstück arbeiten.

## Patentansprüche

1. Verfahren zur reaktiven Oberflächenbehandlung mit erwünschter Wirkungsverteilung entlang einer Werkstücksoberfläche, bei dem in eine Behandlungskammer ein Arbeitsgas aus mehreren Einlassöffnungen eingelassen wird, durch mehrere Absaugöffnungen Gas aus der Behandlungskammer abgesaugt wird, wobei die Einlass- und Absaugöffnungen einander benachbart über einem Bereich der zu behandelnden Oberfläche liegen, mit im wesentlichen dazu senkrechten Oeffnungsachsen, dadurch gekennzeichnet, dass durch Vorgabe des Abstandes zwischen benachbarten Einlass- und Absaugöffnungen, des Abstandes zwischen benachbarten Einlass- und Absaugöffnungen und den zugeordneten Bereichen, der Gaseinlass- und Gasabsaugungsverhältnisse, an den Bereichen selektiv eine Gasströmung zwischen zugeordneter Einlassöffnung, Bereich und Absaugöffnung erzeugt wird und die Wirkungsverteilung durch Vorgabe der Verteilung der selektiv erzeugten Gasströmungen auf die gewünschte Wirkungsverteilung gestellt wird.

2. Verfahren nach Anspruch 1, dadurch gekennzeichnet, dass je eine Einlassöffnung und, ihr benachbart, mehrere Absaugöffnungen vorgesehen werden.

3. Verfahren nach einem der Ansprüche 1 oder 2, dadurch gekennzeichnet, dass je eine Absaugöffnung vorgesehen wird und, ihr benachbart, mehrere Einlassöffnungen und der Gaseinlass auf die mehreren Einlassöffnungen zur Wirkung gebracht wird.

4. Verwendung des Verfahrens nach einem der Ansprüche 1 bis 3 für CVD-Verfahren, insbesondere für pyrolytische CVD-Verfahren.

5. Verwendung des Verfahrens nach einem der Ansprüche 1 bis 3 für Verfahren mit elektrischer DC- oder AC-Entladung.

6. Verwendung des Verfahrens nach Anspruch 5 mit DC-Bias des Werkstückes.

7. Verwendung des Verfahrens nach einem der Ansprüche 1 bis 3 für reaktive PVD-Verfahren.

## Claims

1. Process for reactive surface treatment with a desired distribution of effect along a workpiece surface, in which a working gas is introduced into a treatment chamber through several inlet openings, gas is extracted from the treatment chamber through several extraction openings, where the inlet and extraction openings lie adjacent to each other above an area of the surface to be treated with opening axes essentially perpendicular thereto, characterized in that by specifying the distance between adjacent inlet and extraction openings, the distance between adjacent inlet and extraction openings and their associated areas, the gas inlet and gas extraction conditions, at the areas a gas flow is generated selectively between associated inlet opening, area and extraction opening and the effect distribution set to the required effect distribution by specifying the distribution of the selectively generated gas flows.

2. Process according to claim 1, characterized in that in each case one inlet opening and adjacent thereto several extraction openings are provided.

3. Process according to claim 1 or claim 2, characterized in that in each case one extraction opening is provided and adjacent thereto several inlet openings and the gas is introduced via the several inlet openings.

4. Use of the process according to any of claims 1 to 3 for CVD processes, in particular for pyrolytic CVD processes.

5. Use of the process according to any of claims 1 to 3 for processes with electric DC or AC discharge.

6. Use of the process according to claim 5 with DC bias of the workpiece.

7. Use of the process according to any of claims 1 to 3 for reactive PVD processes.

## Revendications

1. Procédé pour le traitement de surface réactif avec une répartition d'action souhaitée le long d'une surface de pièce, selon lequel un gaz de travail est introduit dans une chambre de traitement par plusieurs ouvertures d'admission et du gaz est aspiré hors de cette chambre par plusieurs ouvertures d'aspiration, étant précisé que les ouvertures d'admission et d'aspiration sont voisines les unes des autres sur une zone de la surface à traiter et présentent des axes d'ouvertures sensiblement perpendiculaires à cette surface, caractérisé en ce que, en prédéfinissant l'écartement entre des ouvertures d'admission et d'aspiration voisines, l'écartement entre des ouvertures d'admission et d'aspiration voisines et les zones associées, et enfin les conditions d'admission et d'aspiration de gaz, on produit sélectivement, au niveau des zones, un écoulement de gaz entre l'ouverture d'admission associée, la zone et l'ouverture d'aspiration, et on règle la répartition d'action suivant la répartition d'action voulue en prédéfinissant la répartition des écoulements de gaz produits sélectivement.

2. Procédé selon la revendication 1, caractérisé en ce qu'on prévoit à chaque fois une ouverture d'admission et, près de celle-ci, plusieurs ouvertures d'aspiration.

3. Procédé selon l'une des revendications 1 ou 2, caractérisé en ce qu'on prévoit à chaque fois une ouverture d'aspiration et, près de celle-ci, plusieurs ouvertures d'admission, et on fait agir l'admission de gaz sur ces ouvertures d'admission.

4. Utilisation du procédé selon l'une des revendications 1 à 3 pour des procédés CVD, en particulier des procédés CVD pyrolytiques.

5. Utilisation du procédé selon l'une des revendications 1 à 3 pour des procédés comprenant une décharge électrique à courant continu ou à courant alternatif.

6. Utilisation du procédé selon la revendication 5 avec une polarisation en courant continu de la pièce à traiter.

7. Utilisation du procédé selon l'une des revendications 1 à 3 pour des procédés PVD réactifs.
